# FASCICULE DE BREVET EUROPEEN

(11) **EP 3 057 130 B1**
(45) Date de publication et mention de la délivrance du brevet: **16.12.2020**
(21) Numéro de dépôt: 16154981.1
(22) Date de dépôt: 10.02.2016
(51) Int. Cl.: H01L 23/498, H01L 23/538, H01L 23/66, H01P 1/20, H01Q 15/00

(54) **DISPOSITIF DE TRANSMISSION RF A REFLECTEUR D'ONDES ELECTROMAGNETIQUES INTEGRE**
RF-ÜBERTRAGUNGSVORRICHTUNG MIT INTEGRIERTEM REFLEKTOR VON ELEKTROMAGNETISCHEN WELLEN
RF TRANSMISSION DEVICE WITH BUILT-IN ELECTROMAGNETIC WAVE REFLECTOR

(30) Priorité: 11.02.2015 FR 1551121
(43) Date de publication de la demande: 17.08.2016
(73) Titulaire: Commissariat à l'Énergie Atomique et aux Énergies Alternatives, 75015 Paris (FR)
(72) Inventeur: LAMY, Yann, 38960 SAINT-ETIENNE DE CROSSEY (FR); DUSSOPT, Laurent, 38100 GRENOBLE (FR); EL BOUAYADI, Ossama, 38000 GRENOBLE (FR); MOKNACHE, Amazir, 94800 Villejuif (FR)
(74) Mandataire: Brevalex

(56) Documents cités:
- DE-A1-102012 107 803
- DE-A1-102013 102 781
- DE-A1-102013 111 569
- JP-A- 2002 510 886
- JP-A- 2005 538 629
- US-A1- 2011 163 457
- US-A1- 2011 170 268
- US-B1- 6 262 495
- US-B1- 6 483 481
- Daniel Frederic Sievenpiper: "High-Impedance Electromagnetic Surfaces", , 1 janvier 1999 (1999-01-01), XP055239203, Los Angeles Extrait de l'Internet: URL:http://optoelectronics.eecs.berkeley.e du/ThesisDan.pdf [extrait le 2016-01-07]
- BROAS R ET AL: "Antennas on high-impedance ground planes", MICROWAVE SYMPOSIUM DIGEST, 1999 IEEE MTT-S INTERNATIONAL ANAHEIM, CA, USA 13-19 JUNE 1999, PISCATAWAY, NJ, USA,IEEE, US, 13 juin 1999 (1999-06-13), page 1245, XP032388078, DOI: 10.1109/MWSYM.1999.779612 ISBN: 978-0-7803-5135-6

## Description

### DOMAINE TECHNIQUE ET ART ANTÉRIEUR

L'invention concerne un dispositif de transmission radiofréquence (RF) comportant au moins un circuit électronique de transmission RF couplé à au moins un réflecteur d'ondes électromagnétiques intégré permettant la réalisation du dispositif avec une faible épaisseur, un fort gain et une bonne efficacité. L'invention s'applique notamment au domaine de la transmission RF pour des fréquences pouvant aller d'environ 1 GHz à environ 300 GHz, et avantageusement entre environ 30 GHz et 250 GHz.

Dans le domaine des dispositifs de transmission RF, l'intégration et le packaging des composants RF, également appelés puces RFIC ou circuit électronique de transmission RF, et de leurs antennes deviennent de plus en plus importants en termes d'encombrement, de performances électriques, de dissipation thermique et de coût. En particulier, les connexions des composants électroniques RF aux antennes deviennent particulièrement critiques en termes de pertes (les interconnexions et les antennes comptent généralement pour environ la moitié des performances globales des dispositifs de transmission), ce qui est d'autant plus vrai que les fréquences ainsi que leur nombre augmentent, comme c'est le cas dans de nombreuses applications à venir destinées à fonctionner à des fréquences comprises entre 30 GHz et 250 GHz. Ainsi, avec l'émergence des communications micro-ondes et millimétriques pour les dispositifs nomades (téléphones, tablettes, PC portables, objets connectés, etc.), il est de plus en plus important de miniaturiser et d'améliorer les performances du packaging comprenant la puce, ou composant, transmetteur (émetteur-récepteur, ou « tranceiver » selon la terminologie anglo-saxonne) RF et les antennes, et cela avec un faible coût pour les applications grand public.

Une première catégorie de packaging de puces RFIC et de leurs antennes est basée sur des technologies multicouches obtenues par lamination de couches organiques et métalliques. Dans ce type de dispositifs, comme par exemple décrits dans les documents US 2009/0256752 A1 et « Low-Cost Antenna-in-Package Solutions for 60-GHz Phased-Array Systems » de D.G. Kam et al., IEEE Electrical Performance of Electronic Packages and Systems Conférence (EPEPS), Oct. 2010, pp. 93-96, des cavités sont prévues pour accueillir et interconnecter la puce RFIC d'une part et pour réaliser des cavités réflectrices, ou résonantes, pour les antennes d'autres part.

Ces dispositifs présentent toutefois plusieurs inconvénients :
- ils sont complexes à réaliser car ils mettent en jeu un grand nombre de couches. Ils sont surtout adaptés pour être réalisés via des techniques de fabrication de type PCB (circuit imprimé), mais ces techniques sont limitées en termes de résolutions de lignes de routage et d'interconnections verticales pouvant être atteintes, ce qui est très pénalisant pour des transmissions hautes fréquences (par exemple supérieures à 60 GHz). De plus, les précisions de positionnement pouvant être obtenues sont également médiocres (généralement supérieures à 500 µm),
- ils sont encombrants, surtout en termes d'épaisseur car les cavités des antennes se superposent à la cavité de la puce,
- ils ne permettent l'utilisation que d'une seule bande fréquentielle pour laquelle les antennes sont optimisées,
- la face arrière de la puce n'est pas ou très peu en contact avec le packaging qui est lui-même en matière organique qui est un mauvais conducteur thermique. Cela a pour conséquence que très peu de chaleur est dissipée de la puce RFIC qui chauffe de plus en plus, surtout quand les fréquences augmentent.

Une autre variante de packaging de puces RFIC et d'antennes est basée sur une intégration de type fan-out (« épanouissement »), également appelé eWLB (embedded die Wafer Level BGA). Dans ce type de dispositifs, comme par exemple décrits dans les documents US 2012/0104574 A1 et « A 77-GHz SiGe Single-Chip Four-Channel Transceiver Module with Integrated Antennas in Embedded Wafer-Level BGA Package » de M. Wojnowski et al., IEEE Electronic Components and Technology Conférence (ECTC), June 2012, pp. 1027-1032, la puce est enrobée, face active vers le bas, dans un matériau polymère (typiquement de l'epoxy) sur lequel sont reconstruits un circuit de routage électrique, les antennes et les plots pour les billes de soudure. Le plan réflecteur des antennes est situé sur le PCB de report, et les antennes rayonnent vers le haut.

Ce type de dispositif présente l'avantage d'avoir un faible coût de réalisation et engendre relativement peu de pertes en hautes fréquences en raison du substrat plastique et/ou du matériau d'enrobage utilisé. Cependant, il nécessite d'avoir un réflecteur situé sur le substrat de report PCB, ce qui limite la densité de routage pouvant être obtenue sur le PCB. De plus, ce type de structure implique de supprimer des billes de connexion sous les antennes, ce qui réduit fortement la fiabilité mécanique de la structure. En outre, les performances des antennes dépendent de manière critique de la hauteur des billes après assemblage qui doit être égale à λ_{g}/4 (λ_{g} étant la longueur d'onde de transmission dans le milieu de propagation), et permet la réalisation d'antennes centrées uniquement sur une seule fréquence. Enfin, la puce RFIC est noyée dans un matériau très peu conducteur de chaleur, ce qui nuit fortement à la dissipation thermique.

Un troisième type de packaging de puces RFIC avec antennes intégrées est décrit dans le document « A compact 3D silicon interposer package with integrated antenna for 60GHz wireless applications » de Y. Lamy et al., IEEE 3D Systems Integration Conférence (3DIC), Oct. 2013, pp. 1-6. Un tel dispositif est basé sur un substrat de silicium sur lequel sont fabriquées les antennes et sur lequel est reporté la puce RFIC. Le document DE102013111569 décrit un autre boîtier microélectronique à antenne intégrée.

Malgré un avantage possible en termes de résolution de motifs pouvant être atteinte, cette solution souffre également d'un certain nombre d'inconvénients :
- un plan réflecteur est nécessairement disposé sur le PCB, ce qui implique des contraintes de design et des pertes de place pour le routage ;
- les billes de connexion sont absentes au niveau du réflecteur, ce qui réduit la fiabilité du billage et donc du maintien mécanique de l'ensemble ;
- la hauteur des billes a un impact très important sur la structure obtenue après assemblage, et donc également sur les propriétés des antennes ;
- une seule hauteur est possible au niveau des antennes, ce qui implique une seule bande de fréquence de transmission possible pour le dispositif;
- la dissipation thermique de la puce RFIC est insuffisante.

D'une manière générale, ces différents dispositifs de transmission RF souffrent d'un encombrement important dû aux cavités ou à la distance devant être maintenue entre les plans réflecteurs et les antennes. Si les plans réflecteurs sont rapprochés pour gagner en compacité, les performances des antennes alors chutent drastiquement (chute du rendement de rayonnement et par conséquent du gain réalisé).

### EXPOSÉ DE L'INVENTION

Un but de la présente invention est de proposer un dispositif de transmission RF ne présentant pas les inconvénients des dispositifs de l'art antérieur, c'est-à-dire dont la structure puisse être réalisée par des procédés classiques de la microélectronique avec un faible coût, qui soit peu encombrant tout en étant performant et compatible avec une transmission selon différentes bandes de fréquences, qui présente un bon maintien mécanique et qui dissipe bien la chaleur produite en son sein.

Pour cela, la présente invention propose un dispositif de transmission RF comprenant au moins :
- un substrat comportant des première et deuxième faces opposées l'une de l'autre ;
- un premier circuit électronique de transmission RF disposé sur et/ou dans le substrat ;
- une première antenne disposée du côté de la première face du substrat, espacée de la première face du substrat et reliée électriquement au premier circuit électronique de transmission RF ;
- un premier réflecteur d'ondes électromagnétiques couplé à la première antenne et comprenant au moins :
   - une première surface à haute impédance comportant au moins plusieurs premiers éléments électriquement conducteurs formant une première structure périodique et disposés sur la première face du substrat en regard de la première antenne ;
   - un premier plan de masse électriquement conducteur disposé au moins partiellement en regard de la première antenne.

Un tel dispositif forme un package miniaturisé d'un ou plusieurs circuits électroniques de transmission RF, ou transmetteurs RF, comportant une ou plusieurs antennes intégrées pouvant avoir une faible épaisseur, un fort gain et une forte efficacité grâce au couplage de la ou des antennes avec un ou plusieurs réflecteurs d'ondes électromagnétiques comprenant une ou plusieurs surfaces à haute impédance couplées à un ou plusieurs plans de masse électriquement conducteur.

Cette intégration du ou des circuits électroniques de transmission RF offre de multiples avantages, notamment dans le domaine des fréquences allant d'environ 1 GHz à environ 300 GHz.

Tout d'abord, un tel dispositif permet, grâce au réflecteur d'ondes électromagnétiques comprenant une surface à haute impédance, de supprimer la cavité réflectrice couplée à l'antenne et qui est nécessaire dans les dispositifs de l'art antérieur, ou de la modifier en la réduisant très fortement par exemple d'un facteur compris entre environ 10 et 100, tout en maintenant, voire même en améliorant, les propriétés de transmission de l'antenne. L'association de la surface à haute impédance et du plan de masse forme un réflecteur d'ondes électromagnétiques qui remplace avantageusement un plan réflecteur métallique classique couplé à une cavité réflectrice de hauteur, ou épaisseur, égale à λ/4 (ce qui correspond à une hauteur, ou épaisseur, de 1,25 mm pour une fréquence de transmission dans l'air égale à 60 GHz), tout en diminuant l'épaisseur, ou la hauteur, nécessaire pour sa réalisation (qui peut être inférieure ou égale à λ/10, soit une épaisseur, ou hauteur, inférieure ou égale à 500 µm), ce qui rend le dispositif intégrable dans des cartes électroniques adaptées pour des téléphones mobiles ou des tablettes tactiles. De plus, la surface à haute impédance écrante, ou masque, en grand partie le substrat qui peut donc être réalisé à partir de matériaux de moins bonne qualité en termes de pertes diélectriques, comme par exemple du silicium standard, sans impacter les performances du dispositif.

Ce dispositif permet également de supprimer la dépendance des épaisseurs respectives du circuit électronique de transmission RF et/ou du substrat par rapport à la longueur d'onde de résonnance de l'antenne, du fait que le design de la surface à haute impédance (choix des matériaux utilisés, dimensions et formes des éléments électriquement conducteurs, etc.) permet d'optimiser les performances des antennes sans imposer de conditions d'épaisseurs strictes ni au circuit électronique de transmission RF, ni au substrat.

Du fait qu'aucune cavité réflectrice n'est présente au niveau de la deuxième face, ou face arrière, du substrat, cette face est entièrement disponible pour réaliser sur celle-ci du routage électrique multicouche mais également des moyens de maintien mécanique du substrat, par exemple des billes de brasure, augmentant ainsi la fiabilité de l'assemblage réalisé. Cette face libre du substrat permet également de disposer librement les interconnexions du package au niveau de celle-ci.

Le circuit électronique de transmission RF étant disposé sur ou dans le substrat, cette structure permet d'optimiser la dissipation thermique du circuit électronique de transmission RF notamment via sa face arrière qui peut être en contact avec le substrat sur toute sa surface. Cette configuration permet de réaliser un report du circuit électronique en contact direct avec le substrat qui est préférentiellement un bon conducteur thermique, par exemple en silicium (dont le coefficient de dissipation thermique est de 150 W/(K.m)).

Ce dispositif permet également de co-intégrer dans un même package, avec une même technologie et une même épaisseur de substrat, plusieurs antennes performantes fonctionnant à des fréquences différentes ou des bandes de fréquences différentes, du fait que l'optimisation de la transmission d'une antenne peut être réalisée grâce au design de la surface à haute impédance pour chaque fréquence et non par les épaisseurs propres du substrat ou d'une cavité réflectrice couplée à cette antenne.

Ce dispositif peut en outre être réalisé via la mise en œuvre d'étapes classiques de la microélectronique (dépôt, photolithographie, etc.), sans avoir à mettre en œuvre de nombreuses étapes complexes de laminage de couches.

Dans ce dispositif, la première antenne et la première surface à haute impédance sont disposées du même côté du substrat (au niveau de la première face du substrat) du côté de la face avant du dispositif. Cette configuration est avantageuse car la première antenne et la première surface à haute impédance peuvent être réalisées au cours d'étapes de réalisation communes, par exemple des étapes de photolithographie et de gravure mises en œuvre pour une seule face du dispositif. Il n'est donc pas nécessaire de mettre en œuvre des étapes distinctes pour la réalisation de ces deux éléments du dispositif, qui nécessitent un alignement face avant/face arrière difficilement réalisable, et qui demandent dans certains cas, par exemple lorsque le substrat comporte du silicium, l'utilisation d'un système de caméra optique ou infrarouge supplémentaire sur l'équipement de lithographie.

La disposition de la première antenne et de la première surface à haute impédance du même côté du substrat est également avantageuse car elle n'impose pas de contrainte pour le choix de l'épaisseur et de la nature du matériau, par exemple diélectrique, se trouvant entre ces deux éléments. Ainsi, si la première surface à haute impédance était disposée du côté de la face arrière du substrat, la distance entre la première antenne et la première surface à haute impédance serait imposée par l'épaisseur de la puce, notamment du substrat, qui est souvent mal maîtrisée, ce qui serait une contrainte additionnelle dans le design de la première antenne et de la première surface à haute impédance.

En outre, du fait que les premiers éléments électriquement conducteurs de la première surface à haute impédance sont disposés sur la première face du substrat en regard de la première antenne, la première surface à haute impédance permet également de réaliser un écrantage (« shielding ») de la première antenne par rapport au substrat, empêchant le rayonnement secondaire de traverser le substrat. Cela permet de réduire la dissipation par rapport à un dispositif classique avec réflecteur quart d'onde, surtout dans le cas d'un substrat comportant un matériau dissipateur comme le silicium.

Un dispositif de transmission, ou transceiver, est un dispositif pouvant émettre et/ou recevoir des ondes.

Le substrat peut correspondre à un support monolithique (monocouche) ou un substrat formé de plusieurs couches et/ou supports assemblés.

Une structure à haute impédance peut correspondre à une structure métallo-diélectrique, généralement composée de cellules élémentaires disposées de façon périodique et dont la période est négligeable devant la longueur d'onde à la fréquence d'intérêt. Elle est caractérisée par sa fréquence de résonance f₀ à laquelle une onde plane en incidence normale est totalement réfléchie avec une phase nulle (coefficient de réflexion d'amplitude 1 et une phase 0). A cette fréquence, l'impédance de sortie présente, théoriquement, une partie réelle (résistance) infinie et une partie imaginaire (réactance) nulle. En pratique, on parle de comportement haute impédance quand la phase du coefficient de réflexion est comprise entre environ [-45°; 45°].

Avantageusement, le premier circuit électronique de transmission RF peut être disposé au niveau de, ou sur, la première face du substrat. Le premier circuit électronique de transmission RF peut toutefois être disposé sur, ou au niveau de, l'une ou l'autre des première et deuxième faces du substrat.

Le premier plan de masse électriquement conducteur peut être disposé sur, ou au niveau de, la deuxième face du substrat. En variante, le premier plan de masse électriquement conducteur pourrait être disposé sur un autre support que la deuxième face du substrat, ce support pouvant se trouver du côté de la deuxième face du substrat. Ainsi, le premier plan de masse électriquement conducteur peut être disposé au niveau de la face arrière du dispositif. L'épaisseur du substrat est ainsi utilisée pour former l'espace entre la première surface à haute impédance et le premier plan de masse électriquement conducteur, ce qui permet de réduire encore plus l'encombrement du dispositif.

Le dispositif peut comporter en outre une première couche diélectrique disposée sur la première face du substrat, entourant le premier circuit électronique de transmission RF et sur laquelle la première antenne est disposée. Une partie de cette première couche diélectrique peut également recouvrir le premier circuit électronique de transmission RF.

En variante de cette première couche diélectrique, le dispositif peut comporter en outre une cavité délimitée par la première surface à haute impédance et par une membrane suspendue sur laquelle au moins la première antenne est disposée.

Une distance entre la première antenne et le premier plan de masse électriquement conducteur peut être inférieure ou égale à environ un dixième d'une longueur d'onde centrale de premiers signaux RF destinés à être émis et/ou reçus par la première antenne. La longueur d'onde centrale de premiers signaux RF destinés à être émis et/ou reçus par la première antenne correspond à une fréquence centrale se situant dans une bande fréquentielle pour laquelle le gain et l'adaptation de l'antenne sont optimaux. Cette fréquence centrale peut correspondre à celle pour laquelle le gain est maximal. Une telle configuration confère une très grande compacité au dispositif.

Chaque premier élément électriquement conducteur de la première surface à haute impédance peut comporter une ou plusieurs portions conductrices, par exemple métalliques, planes disposées les unes à côté des autres et/ou dans différents plans superposés les uns aux autres, la première surface à haute impédance pouvant comporter en outre une deuxième couche diélectrique dans laquelle sont disposés les premiers éléments électriquement conducteurs.

Dans ce cas, chaque premier élément électriquement conducteur de la première surface à haute impédance peut comporter en outre au moins une portion conductrice, par exemple métallique, verticale reliée à la ou au moins à une des portions conductrices planes dudit premier élément électriquement conducteur.

Le dispositif peut comporter en outre :
- plusieurs premiers vias électriquement conducteurs traversant au moins le substrat et reliés électriquement au premier circuit électronique de transmission RF, et/ou
- plusieurs deuxièmes vias électriquement conducteurs traversant au moins le substrat et disposés autour de la première antenne en formant un anneau de garde autour de la première antenne, et/ou
- plusieurs troisièmes vias thermiquement conducteurs traversant au moins le substrat et disposés sous le premier circuit de transmission RF.

Les premiers vias électriquement conducteurs servent dans ce cas de connexions électriques d'entrée et/ou de sortie reliées au premier circuit électronique de transmission RF. Ces premiers vias peuvent être reliés électriquement à un circuit imprimé auquel le substrat est solidarisé.

Les deuxièmes vias électriquement conducteurs forment un anneau de garde autour de la première antenne ce qui permet d'isoler, du point de vue électromagnétique la première antenne vis-à-vis d'autres éléments, comme par exemple d'autres antennes et réduire ainsi fortement la diaphonie (« cross talk ») entre elles.

Les troisièmes vias thermiquement conducteurs qui sont disposés sous le premier circuit de transmission RF participent activement à la dissipation de la chaleur générée par ce circuit grâce à la grande conductivité thermique de ces troisièmes vias. C'est particulièrement le cas lorsque le matériau des troisièmes vias est métallique, par exemple du cuivre, qui est un excellent conducteur thermique et électrique.

Les troisièmes vias thermiquement conducteurs peuvent être électriquement conducteurs. Ainsi, ces troisièmes vias peuvent permettre de réaliser un routage électrique.

Le dispositif peut comporter en outre au moins :
- une deuxième antenne disposée du côté de la première face du substrat, espacée de la première face du substrat et reliée électriquement au premier circuit électronique de transmission RF ;
- un deuxième réflecteur d'ondes électromagnétiques couplé à la deuxième antenne et comprenant au moins :
   - une deuxième surface à haute impédance comportant au moins plusieurs deuxièmes éléments électriquement conducteurs formant une deuxième structure périodique et disposés sur la première face du substrat en regard de la deuxième antenne ;
   - un deuxième plan de masse électriquement conducteur disposé au moins partiellement en regard de la deuxième antenne.

Dans ce cas, les avantages précédemment exposés relatifs à la disposition de la première antenne et de la première surface à haute impédance du même côté du substrat, et de la disposition des premiers éléments électriquement conducteurs de la première surface à haute impédance sur la première face du substrat en regard de la première antenne, se retrouvent également pour la deuxième antenne et la deuxième surface à haute impédance.

Le dispositif peut ainsi comporter plusieurs antennes pouvant réaliser des transmissions de signaux RF à des fréquences ou bandes de fréquences différentes. Une telle configuration est par exemple avantageuse dans le cas du déploiement des futurs systèmes 5G qui vont faire appel à plusieurs types de fréquences millimétriques: par exemple 60 GHz pour le réseau cellulaire et 80 GHz pour du « backhauling » ou liaison point à point.

En variante, le dispositif peut comporter en outre au moins :
- un deuxième circuit électronique de transmission RF disposé sur et/ou dans le substrat ;
- une deuxième antenne disposée du côté de la première face du substrat, espacée de la première face du substrat et reliée électriquement au deuxième circuit électronique de transmission RF ;
- un deuxième réflecteur d'ondes électromagnétiques couplé à la deuxième antenne et comprenant au moins :
   - une deuxième surface à haute impédance comportant au moins plusieurs deuxièmes éléments électriquement conducteurs formant une deuxième structure périodique et disposés sur la première face du substrat en regard de la deuxième antenne ;
   - un deuxième plan de masse électriquement conducteur disposé au moins partiellement en regard de la deuxième antenne.

Là encore, les avantages précédemment exposés relatifs à la disposition de la première antenne et de la première surface à haute impédance du même côté du substrat, et de la disposition des premiers éléments électriquement conducteurs de la première surface à haute impédance sur la première face du substrat en regard de la première antenne, se retrouvent également pour la deuxième antenne et la deuxième surface à haute impédance.

Là aussi, le dispositif peut ainsi réaliser des transmissions de signaux à des fréquences différentes comme expliqué plus haut.

Le deuxième circuit électronique de transmission RF est avantageusement disposé au niveau de, ou sur, la première face du substrat, mais il peut être disposé indépendamment sur, ou au niveau de, l'une ou l'autre des première et deuxième faces du substrat.

Le deuxième plan de masse électriquement conducteur peut être disposé sur, ou au niveau de, la deuxième face du substrat. En variante, le deuxième plan de masse électriquement conducteur pourrait être disposé sur un autre support que la deuxième face du substrat.

Les premiers et deuxièmes éléments électriquement conducteurs des première et deuxième surfaces à haute impédance peuvent être disposés dans une même deuxième couche diélectrique sur laquelle est disposé au moins le premier circuit électronique de transmission RF.

Le dispositif peut comporter en outre un circuit imprimé auquel le substrat est solidarisé et auquel au moins le premier circuit électronique de transmission RF est relié électriquement.

De manière avantageuse, le substrat peut être relié mécaniquement et électriquement au circuit imprimé par l'intermédiaire d'une pluralité de billes conductrices, par exemple métalliques, régulièrement réparties sur la deuxième face du substrat.

L'invention concerne également un procédé de réalisation d'un dispositif de transmission RF, comprenant au moins les étapes de :
- réalisation, sur une première face d'un substrat, d'une première surface à haute impédance comportant au moins plusieurs premiers éléments électriquement conducteurs formant une première structure périodique ;
- report d'un premier circuit électronique de transmission RF sur et/ou dans le substrat ;
- réalisation d'une première antenne disposée du côté de la première face du substrat et en regard des premiers éléments électriquement conducteurs, espacée de la première face du substrat et reliée électriquement au premier circuit électronique de transmission RF ;
- réalisation d'un premier plan de masse électriquement conducteur au moins partiellement en regard de la première antenne ;
   et dans lequel la première surface à haute impédance et le premier plan de masse électriquement conducteur forment ensemble un premier réflecteur d'ondes électromagnétiques couplé à la première antenne.

Le procédé peut comporter en outre les étapes de :
- réalisation d'au moins une deuxième antenne disposée du côté de la première face du substrat, espacée de la première face du substrat et reliée électriquement au premier circuit électronique de transmission RF ou à un deuxième circuit électronique de transmission RF reporté sur et/ou dans le substrat ;
- réalisation d'au moins un deuxième réflecteur d'ondes électromagnétiques couplé à la deuxième antenne et comprenant au moins :
   - une deuxième surface à haute impédance comportant au moins plusieurs deuxièmes éléments électriquement conducteurs formant une deuxième structure périodique et disposés sur la première face du substrat en regard de la deuxième antenne ;
   - un deuxième plan de masse électriquement conducteur disposé au moins partiellement en regard de la deuxième antenne.

L'invention peut s'appliquer avantageusement à différentes applications telles que :
- les communications sans fil à courte portée (typiquement réalisées à 60 GHz) comme par exemple les communications très haut débit de type WiGig, WiHD, HDMI wireless, etc. ;
- les réseaux de capteurs ;
- les radars automobiles (fonctionnant notamment à des fréquences de 24 GHz, 77GHz, etc.) ;
- l'imagerie et la sécurité (transmission de signaux mmW et THz) ;
- les radars avioniques millimétriques (transmission à 90 GHz) ;
- les communications sans fils haut débit de type 4G ou 5G (ou LTE pour « Long Term Evolution » en terminologie anglo-saxonne) et dans les cellules localisées (« small cells » en terminologie anglo-saxonne) ou les liaisons point-à-point (« backhauling » en terminologie anglo-saxonne) .

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- les figures 1 et 4 représentent un dispositif de transmission RF, objet de la présente invention, selon un premier mode de réalisation ;
- les figures 2 et 3 représentent un exemple de réalisation d'éléments électriquement conducteur d'une surface à haute impédance d'un dispositif de transmission RF, objet de la présente invention ;
- les figures 5 et 6 représentent une partie d'un dispositif de transmission RF, objet de la présente invention, selon un deuxième mode de réalisation;
- la figure 7 représente une partie d'un dispositif de transmission RF, objet de la présente invention, selon une variante du premier mode de réalisation.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

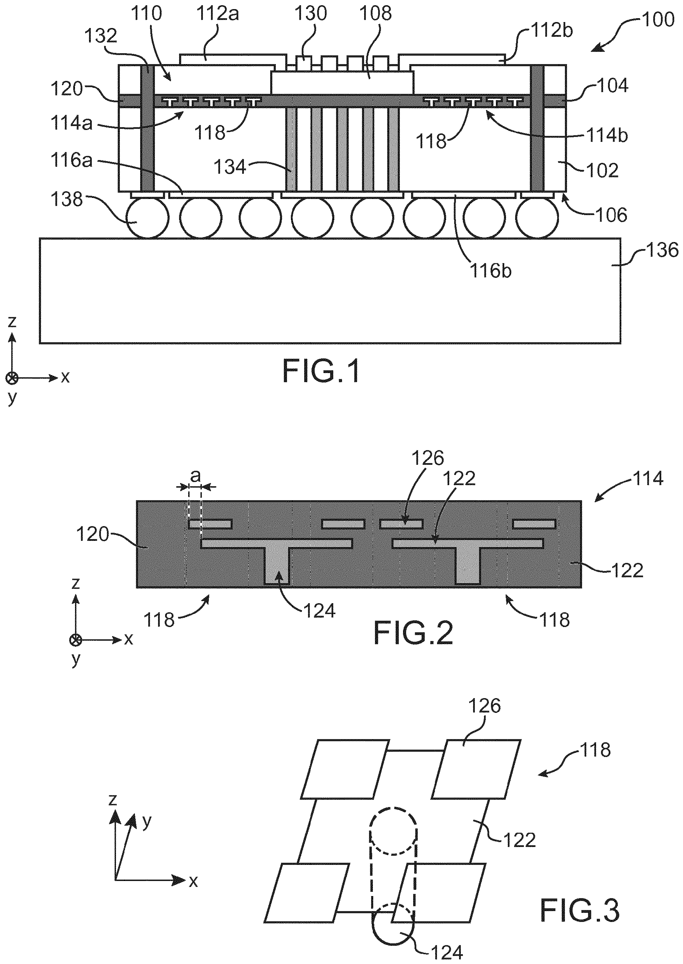

On se réfère tout d'abord à la figure 1 qui représente un dispositif 100 de transmission RF selon un premier mode de réalisation. Le dispositif 100 est destiné à émettre et/ou recevoir des signaux RF de fréquence par exemple comprise entre environ 1 GHz et 300 GHz, ici égale à 60 GHz.

Le dispositif 100 comporte un substrat 102. Le matériau du substrat 102 est avantageusement choisi parmi les matériaux qui sont peu conducteurs électriques (ayant une haute résistivité, par exemple supérieure à environ 1 kOhm.cm), bons conducteurs thermiques (dont la conduction thermique est de préférence supérieure à environ 10 W/K.m), très peu dissipatif dans la gamme des longueurs d'ondes des signaux RF destinés à être émis et/ou reçus par la dispositif 100, et qui permet la mise en œuvre de procédés de réalisation de micro-connectiques de très bonne résolution (par exemple de dimensions inférieures à environ 1 µm) pour la réalisation de lignes de routage, de surfaces haute impédance et d'antennes de manière collective. De plus, ce substrat 102 est de préférence le moins coûteux possible. Un des matériaux remplissant ces critères est par exemple le silicium. L'épaisseur du substrat 102 est avantageusement choisie telle que le substrat 102 soit le plus fin possible tout en étant suffisamment rigide pour être manipulé. Cette épaisseur est par exemple comprise entre environ 50 µm et 500 µm, avantageusement comprise entre environ 200 µm et 300 µm (ce qui est plus fin que les structures de l'art antérieur dont les épaisseurs sont typiquement comprises entre environ 500 µm et 2 mm).

Le substrat 102 comporte une première face 104, formant ici une face avant du substrat 102, et une deuxième face 106 opposée à la première face 104 et formant ici une face arrière du substrat 102.

Le dispositif 100 comporte également un circuit électronique par exemple sous forme de puce, ou circuit intégré, de transmission RF 108, disposé sur la première face 104 du substrat 102. La face arrière du circuit 108 est disposée du côté du substrat 102, et la face active du circuit 108, c'est-à-dire celle au niveau de laquelle se trouvent les plots d'entrée et de sortie du circuit 108, se trouve du côté opposé au substrat 102. Le circuit 108 a par exemple une épaisseur (dimension selon l'axe Z) comprise entre environ 10 µm et 300 µm, avantageusement entre environ 50 µm et 100 µm. Une telle épaisseur peut être obtenue grâce à la mise en œuvre d'un amincissement du circuit 108. Le circuit 108 peut être maintenu au substrat 102 grâce à une colle ou graisse thermiquement conductrice.

Le circuit 108 est entouré d'une couche diélectrique 110 formée sur la première face 104 du substrat 102 et dont l'épaisseur est par exemple égale à ou proche de celle du circuit 108. Il est possible que l'épaisseur de la couche diélectrique 110 soit légèrement supérieure (par exemple de 10 µm à 50 µm en plus) à celle du circuit 108, la couche diélectrique 110 enrobant, ou recouvrant, dans ce cas le circuit 108. L'épaisseur de la couche diélectrique 110 est typiquement comprise entre environ 10 µm et 300 µm. La couche diélectrique 110 comporte par exemple de l'oxyde, tel que du SiO₂, du nitrure, tel que du SiN, ou préférentiellement un polymère photosensible, tel que du SiNR, BCB, Intervia, etc.). Le matériau de la couche diélectrique 110 est avantageusement choisi parmi ceux qui sont de très bons isolants et qui sont faiblement dissipatifs dans la gamme de fréquences de fonctionnement du dispositif 100. De plus, la permittivité et la perméabilité du matériau de la couche diélectrique 110 sont de préférence connues afin de favoriser les performances de la ou des antennes 110 via le choix judicieux des paramètres des surfaces à haute impédance décrites plus loin. Enfin, la face supérieure de la couche diélectrique 110 est avantageusement plane grâce à l'utilisation d'un matériau dit « planarisant », comme par exemple certains polymères, qui permettent d'avoir une surface plane malgré l'épaisseur du circuit 108 recouvert, ou bien grâce à une planarisation (par exemple un CMP) mise en œuvre après le dépôt de ce matériau diélectrique.

Le circuit 108 est relié électriquement à une ou plusieurs antennes 112 disposées sur la couche diélectrique 110. Sur l'exemple de la figure 1, le dispositif comporte deux antennes 112a, 112b, l'une pour émettre des signaux RF et l'autre pour recevoir des signaux RF. Les antennes 112a, 112b sont par exemple formées par des lignes métalliques s'étendant sur la couche diélectrique 110, à côté du circuit 108. Les antennes 112a, 112b sont par exemple de type dipôle. Les antennes 112a, 112b peuvent être reliées électriquement au circuit 108 notamment par lignes d'interconnexions 130 s'étendant sur la couche diélectrique 110 et par des vias conducteurs traversant le matériau diélectrique de la couche 110 recouvrant le circuit 108. Les portions conductrices formant les antennes 112a, 112b ainsi que les lignes d'interconnexions électriques 130 reliant les antennes 112a, 112b au circuit 108 peuvent avoir une épaisseur comprise entre environ 0,5 µm et 10 µm.

Le dispositif 100 comporte également un ou plusieurs réflecteurs d'ondes électromagnétiques, chacun associé à une antenne 112. Chaque réflecteur d'ondes électromagnétiques est formé :
- d'une surface à haute impédance 114 disposée sur la première face 104 du substrat 102, en regard de l'antenne 112 à laquelle le réflecteur d'ondes électromagnétiques est associé, et entre le substrat 102 et la couche diélectrique 110, et
- d'un plan de masse 116 électriquement conducteur disposé sur la deuxième face 106 du substrat 102 et aligné (selon l'axe Z sur la figure 1) vis-à-vis de l'antenne 112 à laquelle le réflecteur d'ondes électromagnétiques est associé (et donc également aligné avec la surface à haute impédance 114 du réflecteur d'ondes électromagnétiques).

Sur l'exemple de la figure 1, l'antenne 112a est couplée à un réflecteur d'ondes électromagnétiques formé par la surface à haute impédance 114a et le plan de masse 116a, et l'antenne 112b est couplé à un autre réflecteur d'ondes électromagnétiques formé par la surface à haute impédance 114b et le plan de masse 116b. Sur l'exemple de la figure 1, chacun des plans de masse 116 correspond à une portion métallique, comportant par exemple un bicouche titane/cuivre, localisée en regard de l'antenne 112 correspondante. En variante, les plans de masse 116 des réflecteurs d'ondes électromagnétiques peuvent être formés par une couche métallique, ou un empilement de couches, non gravée recouvrant la deuxième face 106 du substrat 102.

Chaque surface à haute impédance 114 comporte plusieurs éléments électriquement conducteurs 118, par exemple métalliques, répétés dans une structure périodique réfléchissant le champ électrique des ondes électromagnétiques atteignant la surface à haute impédance 114 et créant les conditions de phase nécessaires pour que le champ magnétique des ondes soit réfléchi grâce à la combinaison de la surface à haute impédance 114 et du plan de masse 116 associé. Les éléments électriquement conducteurs 118 peuvent être réalisés avec les métaux généralement utilisés en microélectronique, comme par exemple le cuivre, l'aluminium, le titane, etc.

Les éléments conducteurs 118 d'une surface à haute impédance 114 forment des motifs géométriques répétés et disposés les uns à côté des autres avec une certaine période. Chaque motif géométrique est formé par au moins une portion de matériau électriquement conducteur, par exemple de forme carrée, hexagonale, etc. Chaque motif géométrique peut également être formé de plusieurs portions de matériau électriquement conducteur planes disposées les unes à côté des autres dans un même plan et/ou disposées dans plusieurs plans superposés les uns au-dessus des autre. Chaque motif géométrique peut également comporter au moins une portion conductrice verticale reliée à la ou l'une des autres portions conductrices du motif géométrique.

Les éléments électriquement conducteurs 118 d'une surface à haute impédance 114 sont avantageusement disposés au sein d'une couche diélectrique 120 à base d'un matériau très faiblement conducteur et très faiblement dissipatif dans la bande de fréquences de fonctionnement du dispositif 100, par exemple un oxyde tel que du SiO₂ ou un nitrure. La couche diélectrique 120 peut également comporter un matériau de perméabilité µ' (propriété magnétique) par exemple de valeur comprise entre environ 1 et 50, par exemple de la ferrite isolante, permettant de concentrer les lignes de champs magnétiques et de renforcer l'effet électromagnétique des surfaces à haute impédance. La couche 120 peut correspondre à un empilement de plusieurs couches diélectriques.

Les surfaces à haute impédance 114 présentent un comportement électromagnétique spécial dans une certaine bande de fréquences. Les structures périodiques des surfaces 114 peuvent présenter une périodicité spatiale et sont considérées comme homogènes par rapport à la longueur d'onde à la fréquence de transmission pour laquelle elles sont conçues. Chaque surface à haute impédance 114 associée à un plan de masse 116 se comporte donc comme une cavité réflectrice, ou résonante, λ/4 couplée à un plan réflecteur « classique » (plan métallique simple) pour l'antenne, d'un point de vue électromagnétique, mais améliore significativement ses performances (gain et directivité notamment) avec des épaisseurs beaucoup plus faibles (λ/10 à À/20) devant la longueur d'onde.

Sur l'exemple de la figure 1, les surfaces à haute impédance 114a, 114b comportent une couche diélectrique 120 qui est commune aux surfaces à haute impédance 114a, 114b et dans laquelle sont disposés les éléments conducteurs 118 des surfaces à haute impédance 114a, 114b.

La ou les surfaces à haute impédance 114 du dispositif 100 ont préférentiellement une épaisseur très réduite, par exemple comprise entre environ 500 nm et 5 µm, par rapport à celle du substrat 102 qui est par exemple comprise entre environ 50 µm et 500 µm. L'épaisseur de chaque motif périodique formé par les éléments électriquement conducteurs 118 est par exemple comprise entre environ 50 nm et 1 µm, par exemple égale à environ 500 nm. L'épaisseur de la couche diélectrique 120 est par exemple comprise entre environ 100 nm et 5 µm.

Les paramètres des éléments formant les surfaces à haute impédance 114 (hauteur des éléments électriquement conducteurs 118, épaisseur de la couche diélectrique 120, nombre et forme des motifs de la structure périodique, etc.) sont choisis de manière précise en prenant en compte l'architecture globale du dispositif 100, et notamment en considérant l'épaisseur du substrat 102, la distance entre les antennes 112 et les surfaces à haute impédance 114 associées, les matériaux utilisés, les propriétés des antennes 112, les fréquences de fonctionnement du dispositif 100, etc. Ceci est réalisé via l'utilisation de logiciel de simulation électromagnétique comme par exemple les logiciels HFSS distribué par la société Ansys, ou le logiciel Momentum distribué par la société Keysight. Les dimensions des motifs et les espaces les séparant doivent être très bien définis dans le module final car à hautes fréquences, par exemple au-dessus de 60 GHz, les dimensions caractéristiques des motifs et des espaces entre eux peuvent être inférieures à quelques microns.

La figure 2 représente une vue de profil de deux éléments électriquement conducteurs 118 d'une surface à haute impédance 114 destinée à être couplée à une antenne 112 réalisant une transmission d'ondes.

La figure 3 représente une vue en trois dimensions d'un de ces éléments électriquement conducteurs 118.

Chaque élément 118 comporte un première portion conductrice 122 plane et de section carrée, dont chaque côté est par exemple égal à environ 175 µm, à laquelle est reliée accessoirement une deuxième portion conductrice 124 verticale de forme cylindrique, par exemple de diamètre égal à environ 60 µm et de hauteur égale à environ 3 µm. Chaque élément 118 comporte également quatre troisièmes portions conductrices 126 planes et de section carrée, de dimensions inférieures à celles de la première portion conductrice 122. Chacun des troisièmes portions conductrices 126 a, de manière avantageuse, des dimensions latérales environ quatre fois plus petites que celles de la première portion 122, soit par exemple un côté égal à environ 45 µm, et chacune disposée en regard d'un des coins de la première portion conductrice 122. Chacune des troisièmes portions conductrices 126 est décalée par rapport à l'un des coins de la première portion conductrice 122 d'une distance « a » par exemple égale à 10 µm. Les troisièmes portions conductrices 126 sont disposées au-dessus de la première portion conductrice 122 et sont séparées de la première portion conductrice 122 par du matériau diélectrique de la couche 120. Lorsque la première portion 122 a une épaisseur égale à environ 1 µm, la hauteur entre la première portion 122 et les troisièmes portions 126 est par exemple égale à environ 6 µm.

Les portions conductrices des éléments 118 comportent ici du cuivre, et la couche diélectrique 120 correspond à une couche de SiO₂.

Des exemples de dimensions et de matériaux sont donnés ci-dessous pour un dispositif 100 transmettant des signaux de fréquence égale à environ 60 GHz :
- substrat 102 comportant du silicium à haute résistivité (résistivité supérieure à 1 kOhm.cm, permittivité égale à 11.9) et une épaisseur égale à environ 200 µm ;
- surfaces à haute impédance 114 comportant des éléments 118 formés à partir d'une couche métallique en cuivre d'épaisseur égale à environ 500 nm, de motifs carrés de côté égal à environ 200 µm, disposés les uns à côté des autres dans un même plan horizontal et espacés les uns des autres d'une distance égale à environ 20 µm ;
- couche diélectrique 110 comportant un polymère de passivation de type ALX ou BCB et d'épaisseur égale à environ 12 µm ;
- antennes 112 et interconnections électriques 130 réalisées à partir d'une couche de cuivre ou d'or d'épaisseur égale à environ 1 µm, les antennes 112 étant de type dipôle replié,
- plans de masse 116 formés d'un bicouche Ti/cuivre d'épaisseur égale à environ 500 nm.

Dans les conditions énoncées ci-dessus, la simulation et la réalisation technologique d'un dispositif de transmission sont en accord et démontrent des propriétés des antennes aussi bonnes (gain d'au moins +5dBi, bande passante d'environ 10 - 15 %) voire meilleure qu'un dispositif de transmission qui comporterait, à la place d'un réflecteur d'ondes électromagnétiques tel que précédemment décrit, une antenne classique couplée à un réflecteur formé d'une simple couche métallique espacée de l'antenne d'une distance égale à λ/4, soit 1,25 mm, ce qui est beaucoup plus encombrant que l'épaisseur du dispositif 100 précédemment décrit.

Dans le but d'améliorer la compacité et la dissipation thermique du circuit 108, il est possible de réaliser des vias conducteurs traversant, par exemple métalliques, dans le substrat 102. Ces vias peuvent avoir plusieurs fonctions :
- ils permettent de sortir des connexions électriques en périphérie du dispositif 100, au niveau de la face arrière du substrat 102, et permettent ainsi de réaliser un billage de connexions électriques après routage en face arrière du substrat 102 ;
- ils permettent de réaliser un anneau de garde autour de chaque antenne 112, isolant ainsi les antennes 112 les unes aux autres en réduisant fortement le cross talk entre celles-ci ;
- des vias placés directement sous le circuit 108 participent activement à la dissipation de la chaleur générée dans le circuit 108 grâce à la grande conductivité thermique du métal (par exemple, la conductivité thermique du cuivre est d'environ 400 W/K.m alors que celle du silicium est d'environ 150 W/K.m et celle d'un substrat organique est inférieure à environ 1 W/K.m). Ces vias de dissipation thermique disposés sous le circuit 108 ne sont pas nécessairement reliés électriquement au circuit 108.

Ces différents vias traversant peuvent être isolés ou non du substrat 102, par exemple en formant une fine couche diélectrique entre le matériau conducteur du via et le semi-conducteur du substrat 102, pour éviter des pertes ou interférences.

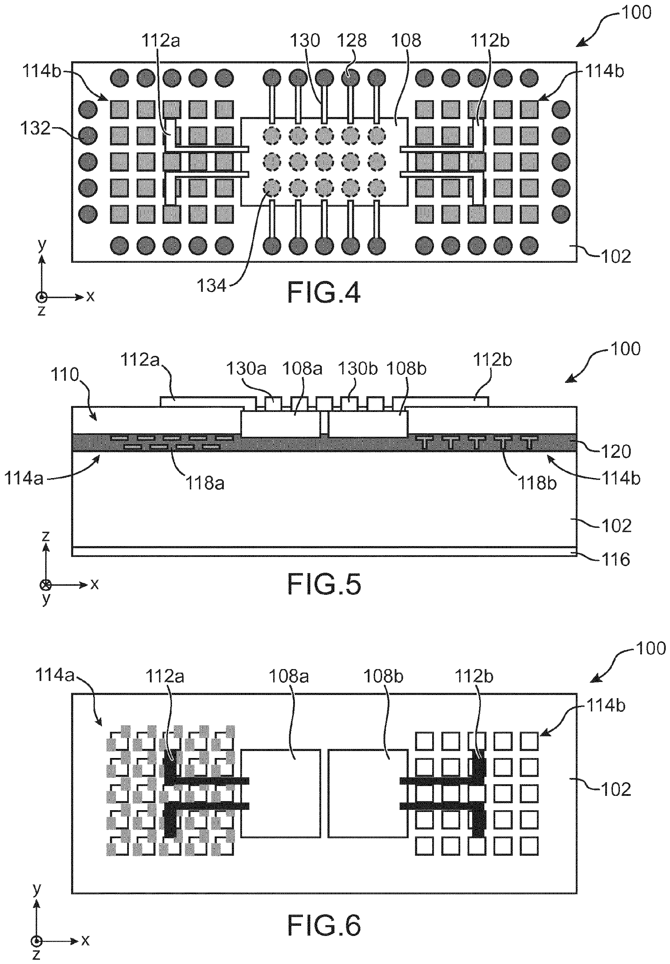

La figure 4 est une vue de dessus schématique du dispositif 100 sur laquelle les différents types de vias conducteurs réalisés dans le substrat 102 sont représentés.

Des premiers vias conducteurs 128 sont réalisés en périphérie du substrat 102 et sont reliés électriquement au circuit 108 par les interconnexions électriques 130 (par exemple formées à partir de la même couche métallique servant à la réalisation des antennes 112). Ces premiers vias 128 débouchent au niveau de la face arrière du substrat 102, traversent le substrat 102 et les couches diélectriques 120 et 110 pour déboucher au sommet de la couche diélectrique 110, à côté du circuit 108.

Des deuxièmes vias conducteurs 132 sont réalisés en périphérie du substrat 102, autour des antennes 112 en formant ainsi des anneaux de garde. Dans l'exemple décrit ici, ces deuxièmes vias conducteurs 132 ne sont pas reliés électriquement au circuit 108. Les deuxièmes vias conducteurs 132 débouchent au niveau de la face arrière du substrat 102, traversent le substrat 102 et les couches diélectriques 120 et 110 pour déboucher au sommet de la couche diélectrique 110.

Des troisièmes vias conducteurs 134 traversent uniquement le substrat 102 et la couche diélectrique 120 et sont disposés sous le circuit 108 et permettent de dissiper la chaleur produite par le circuit 108.

La face arrière 106 du substrat 102 est recouverte au moins partiellement par une couche électriquement conductrice ou des portions électriquement conductrices qui forment notamment les plans de masse 116, mais également des supports conducteurs permettant d'assembler le substrat 102 sur un circuit imprimé 136 (PCB) via des billes 138, ou microbilles, réalisées à partir d'un matériau de brasure. Du fait que les plans de masse 116 sont disposés directement contre la face arrière 106 du substrat 102, il est possible de recouvrir entièrement la face arrière du substrat 102 par des billes 138. Au vu des grandes dimensions du dispositif 100 dans le cas de multiples antennes (environ 15x15 mm² voire plus), cette répartition homogènes des billes 138 au niveau de l'ensemble de la face arrière 106 du substrat 102 assure une très bonne fiabilité de connexion entre le substrat et le circuit imprimé 136. En outre, certaines des billes 138 assurent des liaisons électriques entre le circuit 108 (par l'intermédiaire des premiers vias 128) et le circuit imprimé 136. En variante, il est possible que les troisièmes vias 134 soient reliés électriquement au circuit 108 au niveau de sa face arrière, et assurent ainsi une ou plusieurs liaisons électriques entre le circuit 108 et le circuit imprimé 136.

Des moyens de liaisons mécaniques et électriques autres que les billes 138 peuvent être utilisés.

En variante de cet assemblage réalisé par les billes 138, le substrat 102 peut être collé directement sur le circuit imprimé 136, et les liaisons électriques entre le circuit 108 et le circuit imprimé 136 sont alors réalisées par des fils électriques (« wire bonding ») reliés à la face avant du circuit 108 et au circuit imprimé 136.

Le dispositif 100 peut être réalisé via la mise en œuvre de techniques de micro-fabrication classiques de la micro-électronique, avec un nombre d'étapes relativement modéré, et donc avec un faible coût. Un exemple d'un procédé de réalisation du dispositif 100 est décrit ci-dessous.

Le procédé est mis en œuvre à partir du substrat 102.

Les éléments électriquement conducteurs 118 des surfaces haute impédance 114 sont réalisés par dépôts métalliques, photolithographie et gravure. La couche diélectrique 120 est formée par des dépôts successifs de matériau diélectrique mis en œuvre lors de la réalisation des différentes portions conductrices des éléments 118.

Le circuit 108 est ensuite reporté sur la couche diélectrique 120. Un amincissement du circuit 108 peut être mis en œuvre préalablement au report qui peut être réalisé par une machine de report par « flip chip » (par exemple du type « datacon 2200+ » commercialisé par la société Besi). Le circuit 108 peut être maintenu au substrat 108 grâce à une colle ou graisse thermiquement conductrice.

Un matériau diélectrique est ensuite déposé par enduction centrifuge (« spin coating »), pulvérisation (« spray coating ») ou lamination, selon la nature du matériau, notamment autour du circuit 108 et sur la couche diélectrique 120, formant ainsi la couche diélectrique 110. La face supérieure de la couche diélectrique 110 est ici plane grâce à l'utilisation d'un matériau diélectrique dit « planarisant », ou via la mise en œuvre d'une planarisation du matériau diélectrique déposé.

Suite au dépôt du matériau diélectrique, des reprises de contacts électriques sont éventuellement réalisées à travers le matériau diélectrique de la couche 110 recouvrant le circuit 108, au niveau des plots de contacts du circuit 108. Ces reprises de contact peuvent être réalisées soit par photolithographie si le matériau de la couche diélectrique 110 est photosensible, soit par lithographie et gravure traditionnelle, soit par gravure laser. Les lignes d'interconnexions conductrices 130 et les antennes 112 sont ensuite réalisées sur cette couche de diélectrique 110, reliées à des plots de contact du circuit 108.

Le substrat 102 peut éventuellement être aminci depuis sa face arrière 106, à son épaisseur finale (par exemple comprise entre environ 50 µm et 500 µm). Une couche métallique est ensuite déposée sur la face arrière 106 du substrat 102 pour former les plans de masse 116, cette couche pouvant être structurée ou non.

Les vias conducteurs 128, 132 et 134 sont ensuite réalisés via des techniques conventionnelles : photolithographie, gravure profonde ou perçage laser, et remplissage par des matériaux conducteurs (cuivre, aluminium, etc.).

En variante, il est possible que ces vias soient réalisés préalablement à la surface haute impédance 118 depuis la face avant du substrat 102. Ces vias sont ensuite révélés au niveau de la face arrière du substrat 102 après un amincissement du substrat 102.

L'ensemble est ensuite solidarisé et relié électriquement au circuit imprimé 136.

Le dispositif 100 précédemment décrit comporte un seul circuit 108 assurant l'émission et la réception de signaux à une même fréquence (par exemple 60 GHz) via deux antennes 112a, 112b chacune couplée à un réflecteur d'ondes électromagnétiques comportant une surface haute impédance 114a, 114b et un plan de masse 116a, 116b.

Dans un deuxième mode de réalisation, il est possible que le dispositif 100 réalise une émission et une réception de signaux à des fréquences différentes l'une de l'autre. Un exemple de dispositif 100 selon ce deuxième mode de réalisation est représenté sur les figures 5 et 6. Sur ces figures, les différents vias conducteurs traversant le substrat 102 et correspondant aux vias 128, 132 et 134 précédemment décrits ne sont pas représentés.

Le dispositif 100 selon ce deuxième mode de réalisation intègre plusieurs antennes 112 (deux antennes 112a, 112b dans l'exemple décrit ici) destinées à émettre/recevoir des signaux de fréquences différentes les unes par rapport aux autres. Dans l'exemple décrit ici, la première antenne 112a est apte à réaliser une émission et une réception de signaux de fréquence égale à 60 GHz, et la deuxième antenne 112b est apte à réaliser une émission et une réception de signaux de fréquence égale à 80 GHz. De plus, chacune de ces antennes 112a, 112b est reliée à un circuit 108a, 108b propre qui lui est associé. En variante, le dispositif 100 pourrait ne comporter qu'un seul circuit 108 apte à gérer les transmissions selon différentes fréquences.

Dans ce deuxième mode de réalisation, le substrat 102 et la couche diélectrique 110 peuvent avoir la même épaisseur que pour le dispositif 100 selon le premier mode de réalisation. Les circuits 108a, 108b ont ici des épaisseurs sensiblement égales (à 10 % près) et sont reportées de manière identique (flip-chip face arrière sur le substrat 102).

Etant donné que les fréquences de transmission pour les deux antennes 112a, 112b sont différentes, les surfaces hautes impédances 114a, 114b couplées à ces antennes 112a, 112b sont formées par des éléments électriquement conducteurs 118a, 118b différents d'une surface à l'autre et formant des structures périodiques différentes pour ces deux surfaces haute impédance 114a, 114b. De manière avantageuse, l'optimisation des performances électromagnétiques respectives de chaque antenne 112a, 112b est réalisée uniquement par une optimisation des designs des motifs des éléments électriquement conducteurs 118a, 118b dans un même matériau diélectrique, par exemple un polymère de type ALX formant la couche 120. En optimisant leur forme, taille, nombre et répartition, il est possible de réaliser deux surfaces à haute impédance conférant aux deux antennes de bonnes performances à des fréquences différentes sur un substrat 102 de même épaisseur.

Si besoin est, le diélectrique des couches 110 et/ou 120 peut être éventuellement différent sous les deux antennes 112a, 112b dans le but d'améliorer de manière indépendante et de manière significative les propriétés électromagnétiques de chacune des surfaces à haute impédance 114a, 114b. Ceci a toutefois pour conséquence de complexifier le procédé de réalisation du dispositif 100 car il faut réaliser en deux temps les deux surfaces à haute impédances 114a, 114b différentes.

Enfin, les plans de masse 116 associés à chaque antenne 112a, 112b sont formés par une même couche métallique 116 non structurée et d'épaisseur sensiblement constante déposée sur l'ensemble de la face arrière 106 du substrat 102. En variante, des plans de masse 116a, 116b formés par des portions distinctes pourraient être réalisés.

Le dispositif 100 selon ce deuxième mode de réalisation peut comporter plus de deux circuits 108 et/ou antennes 112 de fréquences différentes.

En variante des deux modes de réalisation précédemment décrits, il est possible que la couche diélectrique 110 et la couche diélectrique 120 soient gravées afin de supprimer les parties de ces couches ne se trouvant pas en regard des antennes 112. Ceci permet notamment de limiter les contraintes induites sur le substrat 102 et de pouvoir de reprendre le contact électriques en faisant passer des lignes conductrices sur les flancs de ces couches diélectriques. Ceci est réalisable facilement si le diélectrique est un polymère photosensible, ou alors par des techniques de photolithographie et gravures classiques.

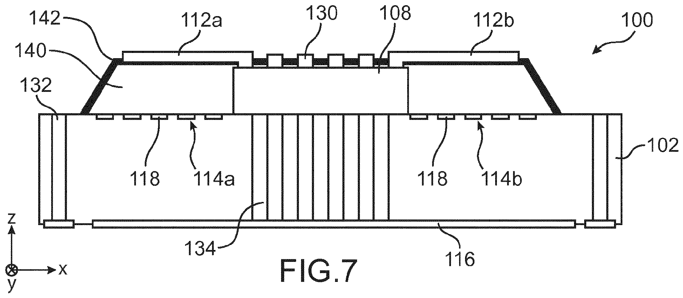

La figure 7 représente le dispositif 100 selon une variante du premier mode de réalisation.

Dans cette variante, la couche diélectrique 110 est remplacée par une cavité 140 formée entre les surfaces à haute impédance 114a, 114b et une membrane suspendue 142 sur laquelle sont formées les antennes 112a, 112b et les lignes d'interconnexions électriques 130. La membrane suspendue est formée par une couche diélectrique d'épaisseur par exemple comprise entre environ 1 µm et 5 µm. La cavité 140 comporte des parois latérales formées par des premières parties de cette couche diélectrique, et une paroi supérieure formée par une deuxième partie de la couche diélectrique au niveau de laquelle se trouvent les antennes 112a, 112b et les lignes d'interconnexions électriques 130. La hauteur, ou l'épaisseur, de la cavité 140 est par exemple égale à l'épaisseur de la couche diélectrique 110. La cavité 140 est remplie d'air.

Cette variante dans laquelle la couche diélectrique 110 est remplacée par la cavité 140 peut s'appliquer également au deuxième mode de réalisation.

## Revendications

1. Dispositif de transmission RF (100) comprenant au moins :
- un substrat (102) comportant des première et deuxième faces (104, 106) opposées l'une de l'autre ;
- un premier circuit électronique de transmission RF (108, 108a) disposé sur et/ou dans le substrat (102) ;
- une première antenne (112a) disposée du côté de la première face (104) du substrat (102), espacée de la première face (104) du substrat (102) et reliée électriquement au premier circuit électronique de transmission RF (108, 108a) ;
- un premier réflecteur d'ondes électromagnétiques couplé à la première antenne (112a) et comprenant au moins :
- une première surface à haute impédance (114a) comportant au moins plusieurs premiers éléments électriquement conducteurs (118, 118a) formant une première structure périodique et disposés sur la première face (104) du substrat (102) en regard de la première antenne (112a) ;
- un premier plan de masse électriquement conducteur (116, 116a) disposé au moins partiellement en regard de la première antenne (112a).

2. Dispositif (100) selon la revendication 1, dans lequel le premier circuit électronique de transmission RF (108a, 108a) est disposé au niveau de la première face (104) du substrat (102).

3. Dispositif (100) selon l'une des revendications précédentes, dans lequel le premier plan de masse électriquement conducteur (116, 116a) est disposé sur la deuxième face (106) du substrat (102).

4. Dispositif (100) selon l'une des revendications précédentes, comportant en outre une première couche diélectrique (110) disposée sur la première face (104) du substrat (102), entourant le premier circuit électronique de transmission RF (108, 108a) et sur laquelle la première antenne (112a) est disposée.

5. Dispositif (100) selon l'une des revendications 1 à 3, comportant en outre une cavité délimitée par la première surface à haute impédance (114a) et par une membrane suspendue sur laquelle au moins la première antenne (112a) est disposée.

6. Dispositif (100) selon l'une des revendications précédentes, dans lequel une distance entre la première antenne (112a) et le premier plan de masse électriquement conducteur (116, 116a) est inférieure ou égale à environ un dixième d'une longueur d'onde centrale de premiers signaux RF destinés à être émis et/ou reçus par la première antenne (112a).

7. Dispositif (100) selon l'une des revendications précédentes, dans lequel chaque premier élément électriquement conducteur (118, 118a) de la première surface à haute impédance (114a) comporte une ou plusieurs portions conductrices planes (122, 126) disposées les unes à côté des autres et/ou dans différents plans superposés les uns aux autres, la première surface à haute impédance (114a) comportant en outre une deuxième couche diélectrique (120) dans laquelle sont disposés les premiers éléments électriquement conducteurs (118, 118a).

8. Dispositif (100) selon la revendication 7, dans lequel chaque premier élément électriquement conducteur (118, 118a) de la première surface à haute impédance (114a) comporte en outre au moins une portion conductrice verticale (124) reliée à la ou au moins à une des portions conductrices planes (122) dudit premier élément électriquement conducteur (118, 118a).

9. Dispositif (100) selon l'une des revendications précédentes, comportant en outre :
- plusieurs premiers vias électriquement conducteurs (128) traversant au moins le substrat (102) et reliés électriquement au premier circuit électronique de transmission RF (108, 108a), et/ou
- plusieurs deuxièmes vias électriquement conducteurs (132) traversant au moins le substrat (102) et disposés autour de la première antenne (112a) en formant un anneau de garde autour de la première antenne (112a), et/ou
- plusieurs troisièmes vias thermiquement conducteurs (134) traversant au moins le substrat (102) et disposés sous le premier circuit de transmission RF (108, 108a).

10. Dispositif (100) selon la revendication 9, dans lequel les troisièmes vias thermiquement conducteurs (134) sont électriquement conducteurs.

11. Dispositif (100) selon l'une des revendications précédentes, comportant en outre au moins :
- une deuxième antenne (112b) disposée du côté de la première face (104) du substrat (102), espacée de la première face (104) du substrat (102) et reliée électriquement au premier circuit électronique de transmission RF (108) ;
- un deuxième réflecteur d'ondes électromagnétiques couplé à la deuxième antenne (112b) et comprenant au moins :
- une deuxième surface à haute impédance (114b) comportant au moins plusieurs deuxièmes éléments électriquement conducteurs (118, 118b) formant une deuxième structure périodique et disposés sur la première face (104) du substrat (102) en regard de la deuxième antenne (112b) ;
- un deuxième plan de masse électriquement conducteur (116, 116b) disposé au moins partiellement en regard de la deuxième antenne (112b).

12. Dispositif (100) selon l'une des revendications 1 à 10, comportant en outre au moins :
- un deuxième circuit électronique de transmission RF (108b) disposé sur et/ou dans le substrat (102) ;
- une deuxième antenne (112b) disposée du côté de la première face (104) du substrat (102), espacée de la première face (104) du substrat (102) et reliée électriquement au deuxième circuit électronique de transmission RF (108b) ;
- un deuxième réflecteur d'ondes électromagnétiques couplé à la deuxième antenne (112b) et comprenant au moins :
- une deuxième surface à haute impédance (114b) comportant au moins plusieurs deuxièmes éléments électriquement conducteurs (118b) formant une deuxième structure périodique et disposés sur la première face (104) du substrat (102) en regard de la deuxième antenne (112b) ;
- un deuxième plan de masse électriquement conducteur (116, 116b) disposé au moins partiellement en regard de la deuxième antenne (112b).

13. Dispositif (100) selon l'une des revendications 11 ou 12, dans lequel le deuxième plan de masse électriquement conducteur (116, 116b) est disposé sur la deuxième face (106) du substrat (102).

14. Dispositif (100) selon l'une des revendications 11 à 13, dans lequel les premiers et deuxièmes éléments électriquement conducteurs (118, 118a, 118b) des première et deuxième surfaces à haute impédance (114a, 114b) sont disposés dans une même deuxième couche diélectrique (120) sur laquelle est disposé au moins le premier circuit électronique de transmission RF (108, 108a).

15. Dispositif (100) selon l'une des revendications précédentes, comportant en outre un circuit imprimé (136) auquel le substrat (102) est solidarisé et auquel au moins le premier circuit électronique de transmission RF (108, 108a) est relié électriquement.

16. Dispositif (100) selon la revendication 15, dans lequel le substrat (102) est relié mécaniquement et électriquement au circuit imprimé (136) par l'intermédiaire d'une pluralité de billes conductrices (138) régulièrement réparties sur la deuxième face (106) du substrat (102).

17. Procédé de réalisation d'un dispositif de transmission RF (100), comprenant au moins les étapes de :
- réalisation, sur une première face (104) d'un substrat (102), d'une première surface à haute impédance (114a) comportant au moins plusieurs premiers éléments électriquement conducteurs (118, 118a) formant une première structure périodique ;
- report d'un premier circuit électronique de transmission RF (108, 108a) sur et/ou dans le substrat (102) ;
- réalisation d'une première antenne (112a) disposée du côté de la première face (104) du substrat (102) et en regard des premiers éléments électriquement conducteurs (118, 118a), espacée de la première face (104) du substrat (102) et reliée électriquement au premier circuit électronique de transmission RF (108, 108a) ;
- réalisation d'un premier plan de masse électriquement conducteur (116, 116a) au moins partiellement en regard de la première antenne (112a) ;
et dans lequel la première surface à haute impédance (114a) et le premier plan de masse électriquement conducteur (116, 116a) forment ensemble un premier réflecteur d'ondes électromagnétiques couplé à la première antenne (114a).

18. Procédé selon la revendication 17, comportant en outre les étapes de :
- réalisation d'au moins une deuxième antenne (112b) disposée du côté de la première face (104) du substrat (102), espacée de la première face (104) du substrat (102) et reliée électriquement au premier circuit électronique de transmission RF (108) ou à un deuxième circuit électronique de transmission RF (108b) reporté sur et/ou dans le substrat (102) ;
- réalisation d'au moins un deuxième réflecteur d'ondes électromagnétiques couplé à la deuxième antenne (112b) et comprenant au moins :
- une deuxième surface à haute impédance (114b) comportant au moins plusieurs deuxièmes éléments électriquement conducteurs (118, 118b) formant une deuxième structure périodique et disposés sur la première face (104) du substrat (102) en regard de la deuxième antenne (112b) ;
- un deuxième plan de masse électriquement conducteur (116, 116b) disposé au moins partiellement en regard de la deuxième antenne (112b).

## Patentansprüche

1. RF-Übertragungsvorrichtung (100), umfassend wenigstens:
- ein Substrat (102) mit einer ersten und einer zweiten Fläche (104, 106), die einander entgegengesetzt sind;
- eine erste elektronische RF-Übertragungsschaltung (108, 108a), die auf oder/und in dem Substrat (102) angeordnet ist;
- eine erste Antenne (112a), die auf der Seite der ersten Fläche (104) des Substrats (102) angeordnet ist, von der ersten Fläche (104) des Substrats (102) beabstandet ist und elektrisch mit der ersten elektronischen RF-Übertragungsschaltung (108, 108a) verbunden ist;
- einen ersten Reflektor für elektromagnetische Wellen, der an die erste Antenne (112a) gekoppelt ist und wenigstens umfasst:
- eine erste hochohmige Oberfläche (114a), die wenigstens mehrere erste elektrisch leitende Elemente (118, 118a) umfasst, die eine erste periodische Struktur bilden und auf der ersten Fläche (104) des Substrats (102) gegenüber der ersten Antenne (112a) angeordnet sind;
- eine erste elektrisch leitende Masse-Ebene (116, 116a), die zumindest teilweise gegenüber der ersten Antenne (112a) angeordnet ist.

2. Vorrichtung (100) nach Anspruch 1, wobei die erste elektronische RF-Übertragungsschaltung (108a, 108a) auf Höhe der ersten Fläche (104) des Substrats (102) angeordnet ist.

3. Vorrichtung (100) nach einem der vorhergehenden Ansprüche, wobei die erste elektrisch leitende Masse-Ebene (116, 116a) auf der zweiten Fläche (106) des Substrats (102) angeordnet ist.

4. Vorrichtung (100) gemäß einem der vorhergehenden Ansprüche, ferner umfassend eine erste dielektrische Schicht (110), die auf der ersten Fläche (104) des Substrats (102) angeordnet ist, die erste elektronische RF-Übertragungsschaltung (108, 108a) umgibt, und auf der die erste Antenne (112a) angeordnet ist.

5. Vorrichtung (100) nach einem der Ansprüche 1 bis 3, ferner umfassend einen Hohlraum, der durch die erste hochohmige Oberfläche (114a) und durch eine aufgehängte Membran begrenzt ist, auf der wenigstens die erste Antenne (112a) angeordnet ist.

6. Vorrichtung (100) nach einem der vorhergehenden Ansprüche, wobei ein Abstand zwischen der ersten Antenne (112a) und der ersten elektrisch leitenden Masse-Ebene (116, 116a) kleiner oder gleich etwa einem Zehntel einer zentralen Wellenlänge von ersten RF-Signalen ist, die dazu bestimmt sind, von der ersten Antenne (112a) gesendet oder/und empfangen zu werden.

7. Vorrichtung (100) nach einem der vorhergehenden Ansprüche, wobei jedes erste elektrisch leitende Element (118, 118a) der ersten hochohmigen Oberfläche (114a) einen oder mehrere ebene leitende Abschnitte (122, 126) umfasst, die nebeneinander oder/und in verschiedenen übereinanderliegenden Ebenen angeordnet sind, wobei die erste hochohmige Oberfläche (114a) ferner eine zweite dielektrische Schicht (120) umfasst, in der die ersten elektrisch leitenden Elemente (118, 118a) angeordnet sind.

8. Vorrichtung (100) nach Anspruch 7, wobei jedes erste elektrisch leitende Element (118, 118a) der ersten hochohmigen Oberfläche (114a) ferner wenigstens einen vertikalen leitenden Abschnitt (124) umfasst, der mit dem oder mit wenigstens einem der ebenen leitenden Abschnitte (122) des ersten elektrisch leitenden Elements (118, 118a) verbunden ist.

9. Vorrichtung (100) nach einem der vorhergehenden Ansprüche, ferner umfassend:
- mehrere erste elektrisch leitende Durchkontaktierungen (128), die wenigstens das Substrat (102) durchqueren und elektrisch mit der ersten elektronischen RF-Übertragungsschaltung (108, 108a) verbunden sind, oder/und
- mehrere zweite elektrisch leitende Durchkontaktierungen (132), die wenigstens das Substrat (102) durchqueren und um die erste Antenne (112a) herum angeordnet sind, wobei sie einen Schutzring um die erste Antenne (112a) bilden, oder/und
- mehrere dritte wärmeleitende Durchkontaktierungen (134), die wenigstens das Substrat (102) durchqueren, und die unter der ersten RF-Übertragungsschaltung (108, 108a) angeordnet sind.

10. Vorrichtung (100) nach Anspruch 9, wobei die dritten wärmeleitenden Durchkontaktierungen (134) elektrisch leitend sind.

11. Vorrichtung (100) nach einem der vorhergehenden Ansprüche, ferner umfassend wenigstens:
- eine zweite Antenne (112b), die auf der Seite der ersten Fläche (104) des Substrats (102) angeordnet ist, von der ersten Fläche (104) des Substrats (102) beabstandet ist und elektrisch mit der ersten elektronischen RF-Übertragungsschaltung (108) verbunden ist;
- einen zweiten Reflektor für elektromagnetische Wellen, der mit der zweiten Antenne (112b) gekoppelt ist und wenigstens umfasst:
- eine zweite hochohmige Oberfläche (114b), die wenigstens mehrere zweite elektrisch leitende Elemente (118, 118b) umfasst, die eine zweite periodische Struktur bilden und auf der ersten Fläche (104) des Substrats (102) gegenüber der zweiten Antenne (112b) angeordnet sind;
- eine zweite elektrisch leitende Masse-Ebene (116, 116b), die zumindest teilweise gegenüber der zweiten Antenne (112b) angeordnet ist.

12. Vorrichtung (100) nach einem der Ansprüche 1 bis 10, ferner umfassend wenigstens:
- eine zweite elektronische RF-Übertragungsschaltung (108b), die auf oder/und in dem Substrat (102) angeordnet ist;
- eine zweite Antenne (112b), die auf der Seite der ersten Fläche (104) des Substrats (102) angeordnet ist, von der ersten Fläche (104) des Substrats (102) beabstandet ist und elektrisch mit der zweiten elektronischen RF-Übertragungsschaltung (108b) verbunden ist;
- einen zweiten Reflektor für elektromagnetische Wellen, der mit der zweiten Antenne (112b) gekoppelt ist und wenigstens umfasst:
- eine zweite hochohmige Oberfläche (114b), die wenigstens mehrere zweite elektrisch leitende Elemente (118b) umfasst, die eine zweite periodische Struktur bilden und auf der ersten Fläche (104) des Substrats (102) gegenüber der zweiten Antenne (112b) angeordnet sind;
- eine zweite elektrisch leitende Masse-Ebene (116, 116b), die zumindest teilweise gegenüber der zweiten Antenne (112b) angeordnet ist.

13. Vorrichtung (100) nach einem der Ansprüche 11 oder 12, wobei die zweite elektrisch leitende Masse-Ebene (116, 116b) auf der zweiten Fläche (106) des Substrats (102) angeordnet ist.

14. Vorrichtung (100) nach einem der Ansprüche 11 bis 13, wobei das erste und das zweite elektrisch leitende Element (118, 118a, 118b) der ersten und zweiten hochohmigen Oberfläche (114a, 114b) in einer gleichen zweiten dielektrischen Schicht (120) angeordnet sind, auf der wenigstens die erste elektronische RF-Übertragungsschaltung (108, 108a) angeordnet ist.

15. Vorrichtung (100) nach einem der vorhergehenden Ansprüche, ferner umfassend eine gedruckte Schaltung (136), mit der das Substrat (102) fest verbunden ist, und an der wenigstens die erste elektronische RF-Übertragungsschaltung (108, 108a) elektrisch angeschlossen ist.

16. Vorrichtung (100) nach Anspruch 15, wobei das Substrat (102) mechanisch und elektrisch mit der gedruckten Schaltung (136) über mehrere leitende Kugeln (138) verbunden ist, die regelmäßig auf der zweiten Fläche (106) des Substrats (102) verteilt sind.

17. Verfahren zur Herstellung einer RF-Übertragungsvorrichtung (100), umfassend wenigstens die Schritte:
- Herstellung, auf einer ersten Fläche (104) eines Substrats (102), einer ersten hochohmigen Oberfläche (114a), die wenigstens mehrere erste elektrisch leitende Elemente (118, 118a) umfasst, die eine erste periodische Struktur bilden;
- Übertragung einer ersten elektronischen RF-Übertragungsschaltung (108, 108a) auf oder/und in das Substrat (102);
- Herstellung einer ersten Antenne (112a), die auf der Seite der ersten Fläche (104) des Substrats (102) und gegenüber den ersten elektrisch leitenden Elementen (118, 118a) angeordnet ist, von der ersten Fläche (104) des Substrats (102) beabstandet und elektrisch mit der ersten elektronischen RF-Übertragungsschaltung (108, 108a) verbunden ist;
- Herstellung einer ersten elektrisch leitenden Masse-Ebene (116, 116a) zumindest teilweise gegenüber der ersten Antenne (112a);
und wobei die erste hochohmige Oberfläche (114a) und die erste elektrisch leitende Masse-Ebene (116, 116a) gemeinsam einen ersten Reflektor für elektromagnetische Wellen bilden, der mit der ersten Antenne (114a) gekoppelt ist.

18. Verfahren nach Anspruch 17, ferner umfassend die Schritte:
- Herstellung von wenigstens einer zweiten Antenne (112b), die auf der Seite der ersten Fläche (104) des Substrats (102) angeordnet ist, von der ersten Fläche (104) des Substrats (102) beabstandet ist und elektrisch mit der ersten elektronischen RF-Übertragungsschaltung (108) oder einer zweiten elektronischen RF-Übertragungsschaltung (108b) verbunden ist, die auf oder/und in das Substrat (102) übertragen wurde;
- Herstellung von wenigstens einem zweiten Reflektor für elektromagnetische Wellen, der mit der zweiten Antenne (112b) gekoppelt ist und wenigstens umfasst:
- eine zweite hochohmige Oberfläche (114b), die wenigstens mehrere zweite elektrisch leitende Elemente (118, 118b) umfasst, die eine zweite periodische Struktur bilden und auf der ersten Fläche (104) des Substrats (102) gegenüber der zweiten Antenne (112b) angeordnet sind;
- eine zweite elektrisch leitende Masse-Ebene (116, 116b), die zumindest teilweise gegenüber der zweiten Antenne (112b) angeordnet ist.

## Claims

1. RF transmission device (100) including at least:
- a substrate (102) comprising first and second faces (104, 106) opposite to each other;
- a first RF transmission electronic circuit (108, 108a) arranged on and/or in the substrate (102);
- a first antenna (112a) arranged on the side of the first face (104) of the substrate (102), spaced apart from the first face (104) of the substrate (102) and electrically connected to the first RF transmission electronic circuit (108, 108a);
- a first electromagnetic wave reflector coupled to the first antenna (112a) and including at least:
- a first high impedance surface (114a) comprising at least several first electrically conducting elements (118, 118a) forming a first periodic structure and arranged on the first face (104) of the substrate (102) opposite the first antenna (112a);
- a first electrically conducting ground plane (116, 116a) arranged at least partially opposite the first antenna (112a).

2. Device (100) according to claim 1, in which the first RF transmission electronic circuit (108a, 108a) is arranged at the first face (104) of the substrate (102).

3. Device (100) according to one of previous claims, in which the first electrically conducting ground plane (116, 116a) is arranged on the second face (106) of the substrate (102).

4. Device (100) according to one of previous claims, further comprising a first dielectric layer (110) arranged on the first face (104) of the substrate (102), surrounding the first RF transmission electronic circuit (108, 108a) and on which the first antenna (112a) is arranged.

5. Device (100) according to one of claims 1 to 3, further comprising a cavity delimited by the first high impedance surface (114a) and by a suspended membrane on which at least the first antenna (112a) is arranged.

6. Device (100) according to one of previous claims, in which a distance between the first antenna (112a) and the first electrically conducting ground plane (116, 116a) is less than or equal to around a tenth of a central wavelength of first RF signals intended to be transmitted and/or received by the first antenna (112a).

7. Device (100) according to one of previous claims, in which each first electrically conducting element (118, 118a) of the first high impedance surface (114a) comprises one or more flat conducting portions (122, 126) arranged beside each other and/or in different planes superimposed on each other, the first high impedance surface (114a) further comprising a second dielectric layer (120) in which are arranged the first electrically conducting elements (118, 118a).

8. Device (100) according to claim 7, in which each first electrically conducting element (118, 118a) of the first high impedance surface (114a) further comprises at least one vertical conducting portion (124) connected to the or at least to one of the flat conducting portions (122) of said first electrically conducting element (118, 118a).

9. Device (100) according to one of previous claims, further comprising:
- several first electrically conducting vias (128) crossing through at least the substrate (102) and electrically connected to the first RF transmission electronic circuit (108, 108a), and/or
- several second electrically conducting vias (132) crossing through at least the substrate (102) and arranged around the first antenna (112a) while forming a guard ring around the first antenna (112a), and/or
- several third heat conducting vias (134) crossing through at least the substrate (102) and arranged under the first RF transmission circuit (108, 108a).

10. Device (100) according to claim 9, in which the third heat conducting vias (134) are electrically conducting.

11. Device (100) according to one of previous claims, further comprising at least:
- a second antenna (112b) arranged on the side of the first face (104) of the substrate (102), spaced apart from the first face (104) of the substrate (102) and electrically connected to the first RF transmission electronic circuit (108);
- a second electromagnetic wave reflector coupled to the second antenna (112b) and including at least:
- a second high impedance surface (114b) comprising at least several second electrically conducting elements (118, 118b) forming a second periodic structure and arranged on the first face (104) of the substrate (102) opposite the second antenna (112b);
- a second electrically conducting ground plane (116, 116b) arranged at least partially opposite the second antenna (112b).

12. Device (100) according to one of claims 1 to 10, further comprising at least:
- a second RF transmission electronic circuit (108b) arranged on and/or in the substrate (102);
- a second antenna (112b) arranged on the side of the first face (104) of the substrate (102), spaced apart from the first face (104) of the substrate (102) and electrically connected to the second RF transmission electronic circuit (108b);
- a second electromagnetic wave reflector coupled to the second antenna (112b) and including at least:
- a second high impedance surface (114b) comprising at least several second electrically conducting elements (118b) forming a second periodic structure and arranged on the first face (104) of the substrate (102) opposite the second antenna (112b);
- a second electrically conducting ground plane (116, 116b) arranged at least partially opposite the second antenna (112b).

13. Device (100) according to one of claims 11 or 12, in which the second electrically conducting ground plane (116, 116b) is arranged on the second face (106) of the substrate (102).

14. Device (100) according to one of claims 11 to 13, in which the first and second electrically conducting elements (118, 118a, 118b) of the first and second high impedance surfaces (114a, 114b) are arranged in a same second dielectric layer (120) on which is arranged at least the first RF transmission electronic circuit (108, 108a).

15. Device (100) according to one of previous claims, further comprising a printed circuit (136) to which the substrate (102) is joined and to which at least the first RF transmission electronic circuit (108, 108a) is electrically connected.

16. Device (100) according to claim 15, in which the substrate (102) is connected mechanically and electrically to the printed circuit (136) through the intermediary of a plurality of conducting beads (138) regularly spread out on the second face (106) of the substrate (102).

17. Method for producing a RF transmission device (100), including at least the steps of:
- forming, on a first face (104) of a substrate (102), a first high impedance surface (114a) comprising at least several first electrically conducting elements (118, 118a) forming a first periodic structure;
- transferring a first RF transmission electronic circuit (108, 108a) onto and/or into the substrate (102);
- forming a first antenna (112a) arranged on the side of the first face (104) of the substrate (102) and opposite the first electrically conducting elements (118, 118a), spaced apart from the first face (104) of the substrate (102) and electrically connected to the first RF transmission electronic circuit (108, 108a);
- forming a first electrically conducting ground plane (116, 116a) at least partially opposite the first antenna (112a);
and in which the first high impedance surface (114a) and the first electrically conducting ground plane (116a, 116a) together form a first electromagnetic wave reflector coupled to the first antenna (114a).

18. Method according to claim 17, further comprising the steps of:
- forming at least one second antenna (112b) arranged on the side of the first face (104) of the substrate (102), spaced apart from the first face (104) of the substrate (102) and electrically connected to the first RF transmission electronic circuit (108) or to a second RF transmission electronic circuit (108b) transferred onto and/or into the substrate (102);
- forming at least one second electromagnetic wave reflector coupled to the second antenna (112b) and including at least:
- a second high impedance surface (114b) comprising at least several second electrically conducting elements (118, 118b) forming a second periodic structure and arranged on the first face (104) of the substrate (102) opposite the second antenna (112b);
- a second electrically conducting ground plane (116, 116b) arranged at least partially opposite the second antenna (112b).
